# EUROPEAN PATENT APPLICATION

(11) **EP 2 458 617 A1**
(43) Date of publication of application: **30.05.2012**
(21) Application number: 10192319.1
(22) Date of filing: 24.11.2010
(51) Int. Cl.: H01J 37/26, H01J 37/304, H01J 37/22, H01J 37/20

(54) **Electron microscope with assistive locating apparatus**

(71) Applicant: FEI Company, Hillsboro, OR 97124-5793 (US)
(72) Inventor: Knippels, Guido, 5481 RA Schijndel (NL); Buijsse, Bart, 5646 JK Eindhoven (NL); De Jong, Frank, 5645 JV Eindhoven (NL); Wagner, Raymond, 4207 BH Gorinchem (NL)
(74) Representative: Bakker, Hendrik

(57) **Abstract**

An imaging apparatus comprising:
An imaging sub-assembly, in which an electron microscope is arranged to acquire an image of a sample that can be located in a sample holder, said image being acquired using an imaging beam that can be switched so as to
produce a flash of imaging electrons,

wherein the apparatus additionally comprises:
A locating sub-assembly, which does not employ electron microscopy, and which can be employed to determine a location of the sample relative to the imaging beam.

The field of detection of the locating sub-assembly may be substantially coincident with the field of view of the imaging sub-assembly, allowing concurrent locating/imaging of the sample. Alternatively, in the case of a moving sample caused to flow through the sample holder, said field of detection may be located "upstream" of said field of view, and a processor can be used to calculate the commencement time of an imaging flash using data that comprise the relative displacement of said fields and the velocity of the sample.

## Description

The invention relates to an imaging apparatus comprising an imaging sub-assembly, in which an electron microscope is arranged to acquire an image of a sample that can be located in a sample holder, said image being acquired using an imaging beam that can be switched so as to produce a flash of imaging electrons.

It should be noted that, as employed throughout this text, the term "sample" should be broadly construed. For example, the term may apply to the whole of a discrete object (such as a neoplasm, or a single biological cell), but also to a sub-component or particular region of such an object (such as a receptor area of a cell, or a flagellum of an organism). Moreover, the term "sample" may embrace non-biological objects, such as molecules/polymers, crystals, semiconductor circuit components, *etc*.

Electron microscopy is a well-known technique for imaging microscopic objects. Generally speaking, an electron microscope comprises:
- An electron source, for producing a beam of electrons.
- An electron-optical column, comprising electron-optical lenses for manipulating the electron beam into a suitable imaging beam.
- A sample holder, for holding and positioning a sample relative to the imaging beam.
- A detector, for detecting electrons emanating from the sample as a result of its interaction with the imaging beam.

This basic genus of apparatus has undergone evolution into a number of well-known apparatus species, such as the Transmission Electron Microscope (TEM), Scanning Electron Microscope (SEM), and Scanning Transmission Electron Microscope (STEM), and also into various sub-species, such as so-called dual-beam electron microscopes (that additionally employ a "machining" beam of ions).

In traditional electron microscopes, the imaging beam is "on" for an extended period of time during a given imaging session. However, recently, electron microscopes have emerged in which imaging occurs on the basis of a relatively short "flash" or "burst" of electrons. Such flash-imaging can be of significant benefit, e.g. in the case of:
- Moving samples, for which a long "exposure time" might result in image blur.
- Sensitive/delicate samples, for which relatively long exposure to imaging electrons might result in radiation-induced damage, e.g. as in the case of certain living cells.

The desired flash can be realized in different manners, e.g. by appropriately switching or shuttering the electron source, or by using (part of) the electron-optical column to briefly manipulate the imaging beam onto and off of the sample, as required. See, for example, the article by LaGrange et al., "Single-shot dynamic transmission electron microscopy for Material Science", in Applied Physics Letters, vol. 89, 044105 (2006)), which describes a TEM that uses a short (∼10 ns) electron pulse with sufficient charge (∼10⁸ electrons per pulse) to perform a single-shot TEM image with 1-10 nm resolution.

A drawback of such flash-type electron microscopes is that, because imaging only occurs in short "bursts", one is basically "in the dark" most of the time as regards the precise position (of a region of interest) of the sample with regard to (a reference point in) the field of view of the electron microscope (pertinently, the (nominal) point/area of intersection of the imaging beam path with the containment plane of the sample within the sample holder). This is a particularly vexing problem in the case of moving samples. For example, the firm *Hummingbird* Scientific in Washington State, USA (www.hummingbirdscientific.com) produces a specialized TEM holder that allows liquid water (or another liquid/solution) to pass through a narrow constriction (∼ 500 nm thick) with TEM-transparent windows, allowing living biological cells to be "fed through" the field of view of a TEM. Viewing living samples in such a water-based environment is very beneficial to the samples themselves; however, since the samples are moving, imaging them with a flash-type TEM will be a process of "hit and miss", whereby several "blind" exposures will have to be made and the microscope operator will just have to hope that a feature of interest is adequately captured by one or more of these exposure events. Needless to say, such an approach is inefficient.

Even in the case of a (substantially) non-moving sample, a similar problem exists. Such a sample is mounted on the sample holder, which then has to be appropriately positioned with respect to the imaging field of the imaging sub-assembly before meaningful imaging can begin. Although the sample holder will generally be mounted to a positioning stage whose positioning can be determined at any time using, for example, multiple-axis encoders or interferometers, the position of the sample itself relative to the stage will be unknown. In existing apparatus, such a sample again has to be sought out by an inefficient "hit and miss" approach as set forth above, whereby the stage is moved in increments and "blind" flash-exposures are made.

It is an object of the present invention to address the issue set forth above. More specifically, it is an object of the present invention to provide a flash-type electron microscope that can be efficiently used to image (moving) samples.

These and other objects are achieved in an imaging apparatus as set forth in the opening paragraph above, characterized in that the apparatus additionally comprises a locating sub-assembly, which does not employ electron microscopy, and which can be employed to determine a location of the sample relative to the imaging beam.

In research leading to the invention, the inventors realized that a "hit-and-miss" approach as described above was essentially unworkable in an industrial context. As a wholly alternative approach, they realized that, to overcome the inefficiencies inherent to the prior art, it was necessary to develop an architecture with which the sample could be accurately located (i.e. its position determined) outside of exposure events (electron flashes). To formulate such a goal initially seemed counter-intuitive, since its realization seemed to be impeded by several significant challenges. For example, the desired architecture would need to have a relatively high resolution, so as to offer useful results when employed in conjunction with electron microscopy. In addition, it would have to be capable of tracking/localizing moving samples, and would have to be compatible with (fragile) biological specimens. At the same time, such architecture would have to be compact and/or have a versatile geometry, in order to allow its use in the generally very cramped space in the vicinity of the sample holder of an electron microscope. Moreover, it would have to be such as to avoid disturbing the operational physics of the employed electron microscope (meaning, for example, that parasitic electromagnetic fields associated with such architecture would have to be appropriately contained). However, the inventors managed to overcome these challenges and realize an innovative architecture that represents a significant improvement to the prior art.

In a particular embodiment of an imaging apparatus according to the invention, a field of view of the imaging sub-assembly is substantially coincident with a field of detection of the locating sub-assembly, thus allowing *concurrent* locating and imaging of the sample. Such a set-up requires the locating sub-assembly to at least partially exist in the cramped vicinity of the sample holder; nevertheless, the inventors managed to overcome this problem. For example, in one suitable approach, the locating sub-assembly comprises a light source and an optical detector. A light beam has the advantage that it doesn't interfere with the operation of the neighboring electron-imaging sub-assembly, can be manipulated into and out of tight confines using relatively simple and compact optics (e.g. comprising a folding mirror), and can be readily used to achieve relatively high-resolution detection. Such an optical approach may take different forms. For example:
(i) The locating sub-assembly may comprise a full optical microscope, allowing its operator to actually image the sample within the field of detection. Such an optical microscope can be disposed adjacent to the electron-optical column of the imaging sub-assembly and, if necessary, the optical axis of the microscope can be bent into and out of the vicinity of the sample using appropriate deflecting optics, such as a set of folding mirrors. In a further refinement of such an approach, the microscope's light source is capable of exciting fluorescence in the sample, and the microscope is a fluorescence microscope. If the sample of interest does not sufficiently fluoresce of its own accord, its fluorescence can be enhanced by "tagging" it with a fluorescence marker: see, for example, the article in Science Daily, September 28, 2010, in which so-called quantum dots are implanted in cells using a nanoneedle: http://www.sciencedaily.com/releases/2010/09/100927131716.htm
(ii) As an alternative, one can embody the locating sub-assembly to comprise a laser backscatter analyzer. Such a device immerses its field of detection in (scanned) laser light, and uses a detector (such as a photodiode/photomultiplier/CCD/CMOS array) to detect light scattered by objects present/moving within that field, such as a particular sample of interest. However, as alternatives to such an optical detection approach, there are also various non-optical detection techniques that can be applied in such an apparatus. For example:
(iii) Detection employing a capacitance analyzer. In such a scenario, a set of (composite) electrodes is used to produce a probing electric field across the field of the detection of the locating sub-assembly. For example, in the case of a sample holder that comprises a containment plane for a (moving) sample (as in the case of a *Hummingbird-type* sample holder as eluded to above, for example, in which case the containment plane is also a flow plane), one can sandwich the containment plane between two planar electrodes, whereby one of the electrodes is provided with a (relatively small) aperture to allow the imaging beam of the imaging sub-assembly to access the containment plane. A (relatively small) electrical potential difference is then applied to these electrodes, thus forming a capacitor in which the containment plane - and any material located therein - acts as dielectric. The presence/flow of a sample in/through the containment plane will locally change the dielectric constant of this dielectric, thus measurably altering the capacitance of the capacitor in a manner that allows the sample to be detected/tracked. If desired, a layer of shielding material can be disposed between this capacitor and the electro-optical column of the imaging sub-assembly - although weak measurement fields in such a capacitor are not expected to significantly affect the imaging beam of the latter.
(iv) Detection employing an ultrasonic analyzer. Ultrasonic acoustic waves provide a means of distinguishing between a (moving) sample and a medium in which it is located, thus allowing the presence of a sample to be detected (and, if necessary, tracked). Such techniques can achieve a resolution of the order of 10 microns, for example. Since this approach employs sound waves, it does not adversely affect the neighboring imaging sub-assembly in any substantial way.

In all cases such as those set out in this paragraph, the operator can detect/follow the presence of the sample directly within the field of view of the imaging sub-assembly, and instigate an imaging flash of electrons when the sample is appropriately positioned within that field.

If desired, an alternative approach can be employed in the case of a moving sample caused to flow through the sample holder. In such an instance, the field of detection of the locating sub-assembly may be located "upstream" of the field of view of the imaging sub-assembly, and a processor can be used to calculate the commencement time of an imaging flash using data that comprise the relative displacement of said fields and the velocity of the sample. In this scenario, there is no longer concurrent locating/imaging of the sample; instead, the timing of a particular flash imaging event is planned on the basis of an upstream detection of the sample, and an associated time-of-travel prediction from the point of detection to the point of imaging. Such an approach has the effect that the locating sub-assembly may now be arranged at a location that is relatively distal (e.g. a few centimeters) from the imaging axis of the imaging sub-assembly, thus allowing more room for the locating sub-assembly, and also impeding possible detrimental influences it might have on the operational physics of the imaging sub-assembly. Although any of the detection techniques (i)-(iv) set forth above can also be applied in this scenario, the aspects of more room / less interference referred to in the previous sentence also allow other detection techniques to be applied. These may, for example, exploit the following devices:
- An X-ray analyzer, i.e. an imaging set-up employing (soft) X-rays.
- A magnetic field analyzer, i.e. a magnetic analog of approach (iii) above, whereby the presence/movement of a sample within a specially created probing magnetic field causes measurable magnetic permeability changes, allowing the sample to be localized/tracked.
- A Scanning Probe Microscope (SPM).
- A Nuclear Magnetic Resonance (NMR) analyzer.

The invention will now be elucidated in more detail on the basis of exemplary embodiments and the accompanying schematic drawings, in which:
Figure 1 renders a longitudinal cross-sectional view of a Transmission Electron Microscope (TEM), such as can be employed as an imaging sub-assembly in an imaging apparatus according to the current invention.
Figure 2 renders a partially perspective / partially cross-sectional view of a portion of an embodiment of a sample holder that can be used in an imaging apparatus according to the present invention.
Figure 3 schematically depicts a portion of an embodiment of an imaging apparatus according to the present invention.
Figure 4 schematically depicts a portion of another embodiment of an imaging apparatus according to the present invention.
Figure 5 schematically depicts an aspect of yet another embodiment of an imaging apparatus according to the present invention.

In the Figures, where pertinent, corresponding parts are indicated using corresponding reference symbols.

### Example 1 (prior art)

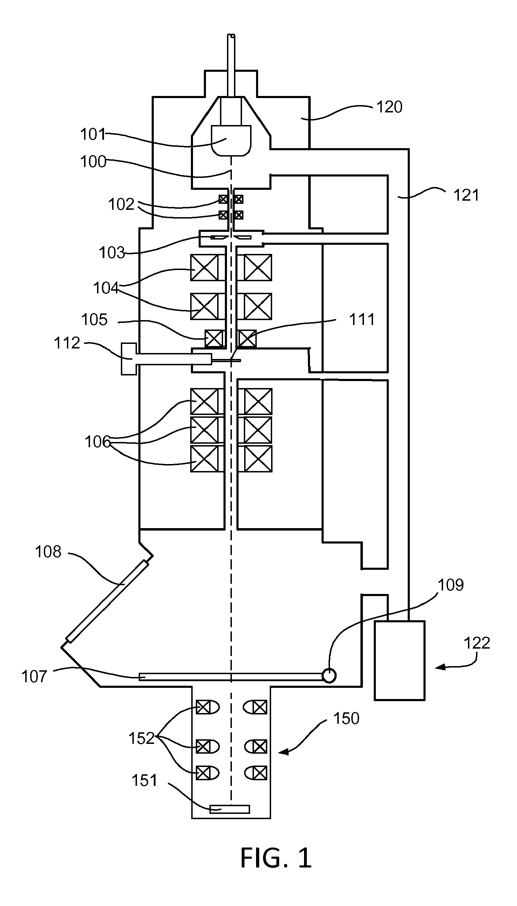

Figure 1 renders a longitudinal cross-sectional view of a known type of Transmission Electron Microscope (TEM), such as can be employed as an imaging sub-assembly in an imaging apparatus according to the current invention.

The depicted TEM comprises a vacuum housing 120 that is evacuated via tube 121 connected to a vacuum pump 122. A particle source in the form of an electron gun 101 produces a beam of electrons along a particle-optical axis (imaging axis) 100. Deflectors 102 centre this beam of particles upon beam limiting aperture 103. The beam then passes through a condenser system comprising two lenses 104.

A sample holder 111 is held by a manipulator (stage assembly) 112 in such a manner that a sample (not depicted) on the sample holder 111 can be positioned in the object plane of the objective lens 105. The sample is imaged by a projection system comprising lenses 106 onto fluorescent screen 107, and can be viewed through a window 108. The fluorescent screen 107 is connected to a hinge 109, and can be retracted / folded away such that the image formed by the projection system 106 impinges upon detector 150. It is noted that, in such an instance, the projection system 106 may need to be re-focused so as to form the image on the detector 150 instead of on the fluorescent screen 107. It is further noted that the projection system 106 will generally additionally form intermediate images at intermediate image planes (not depicted).

The detector 150 comprises a Charge Coupled Device (CCD) 151 for detecting impinging electrons. As an alternative to electron detection, one can also use a CCD that detects light - such as the light emitted by a Yttrium Antimony Garnet (YAG) crystal (for example) that is bonded to the CCD, or connected thereto by optical fibres (for example). In such an indirect detector, the YAG crystal emits a number of photons when an electron hits the crystal, and a portion of these photons is detected by the CCD camera; in direct detectors, electrons impinge on the semiconductor chip of the CCD and generate electron/hole pairs, thereby forming the charge to be detected by the CCD chip. In both cases, multipoles 152 can be used to correct distortions introduced by the projection system 106 prior to detection.

The electron source 101 can, for example, be a field emitter gun, a Schottky emitter, or a thermionic electron emitter. The electrons produced by the source 101 are accelerated to an adjustable energy of typically 80 - 300 keV (although TEMs using electrons with an adjustable energy of 50 - 500 keV, for example, are also known). The accelerated electron beam then passes through a beam limiting aperture / diaphragm 103 provided in a platinum sheet. To align the electron beam properly to the aperture 103, the beam can be shifted and tilted with the aid of deflectors 102, so that the central part of the beam passes through the aperture 103 along particle-optical axis 100. Focusing of the beam is achieved using magnetic lenses 104 of the condenser system, together with (part of the) objective lens 105. Objective lens 105 often immerses the object in its magnetic field. The beam irradiating the sample may be a focused beam scanned over the sample, or it may be a parallel beam. Often, deflectors (not depicted) are used to centre the beam on a region of interest on the sample, or to scan the beam over the surface of the sample.

Where the imaging beam impinges on the sample, secondary radiation is generated in the form of secondary electrons, light, X-rays etc. This radiation may be detected by detectors (not shown). A part of the beam is transmitted through the sample, and is then imaged by the lenses 106 of the projection system onto a fluorescent screen 107. The enlarged image formed on the screen typically has a magnification in the range 10³x-10⁶x, and may show details as small as 0.1 nm or less, for example.

The image formed on the fluorescent screen 107 and on the CCD camera 151 is generally aberrated due to distortion produced by the lenses 106. To correct such distortion, multipoles 152 are used, each of which may be a magnetic multipole, an electrostatic multipole or a combination thereof. In the current case, three levels/sets of multipoles are shown; however, a smaller number may also suffice, or, in other cases, a larger number of multipoles may be necessary, in order to correct the distortions with greater accuracy.

Assuming a CCD with (for example) 5k x 5k pixels and an image resolution of 0.1 nm, the Field of View (FoV) of the TEM may be as small as 500 x 500 nm². However, at a relatively low magnification, a FoV as large as 500 x 500 µm² may be achieved.

It should be noted that Figure 1 only shows a schematic rendition of a typical TEM, and that, in reality, a TEM will generally comprise many more deflectors, apertures, etc. Also, TEMs having correctors for correcting the aberration of the objective lens 105 are known, said correctors employing multipoles and round lenses. Moreover, other detectors (as alluded to above) may be used, such as secondary electron detectors, X-ray detectors, etc; these detectors may be positioned at the side of the sample facing the gun 101, or the side of the sample facing detector 150.

In the context of the present invention, the set-up shown in Figure 1 will be embodied so as to produce a "flash-type" imaging beam. To this end, one may adopt techniques such as the following:
- Embodying the electron gun 101 to be rapidly switchable, enabling it to produce a short pulse of electrons when required.
- Placing a rapidly operable shutter at some point between the electron gun 101 and the sample holder 111, allowing the imaging beam to be kept generally eclipsed until an imaging flash is required, whence the shutter is rapidly opened and closed.
- Using one or more of the various deflecting elements 102, 104, 105 to keep the imaging beam deflected off of the imaging axis 100 until such time as an imaging flash is required, whence the beam can be rapidly deflected onto and off of the axis 100.

The skilled artisan will readily understand how such techniques (and other appropriate alternative techniques) can be implemented and applied.

The sample holder 111 may be a conventional type of sample holder for holding a static sample in a containment plane. Alternatively, the sample holder can be of a special type that accommodates a moving sample in a flow plane/channel that can contain a stream of liquid water or other solution. Such a special sample holder will now be described.

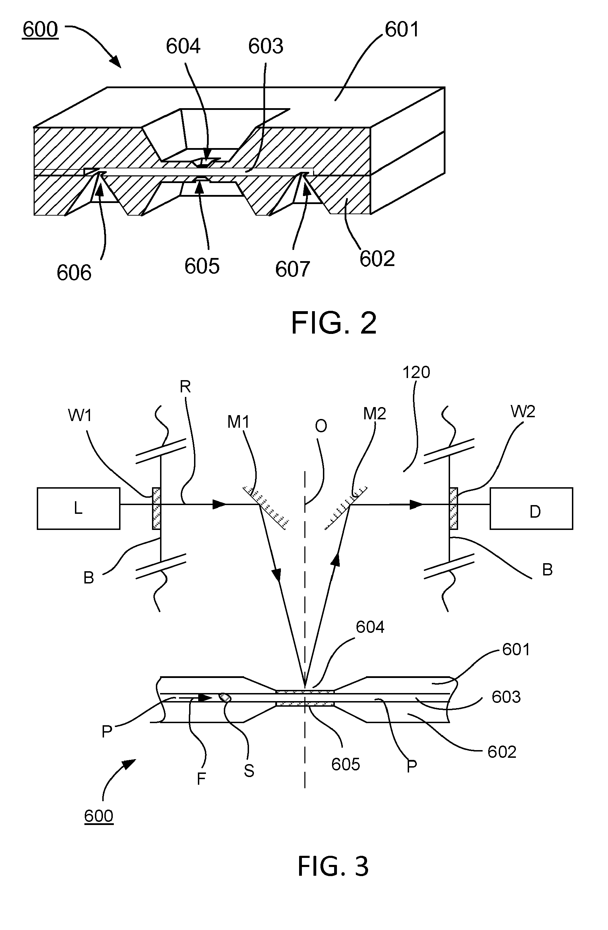

Figure 2 renders a partially perspective / partially cross-sectional view of a portion of an embodiment of a sample holder 600 that can be used in an imaging apparatus according to the present invention. The sample holder 600 comprises two plates 601, 602 of rigid material that have been machined and then adjoined to one another. A hollow region has been machined out of a major surface of plate 601 such that, when abutted against plate 602, an interposed channel 603 is formed. Both plates 601, 602 have been provided with a central depression in which TEM-transparent windows 604, 605 are located, respectively, in such a manner as to oppose one another across the intervening channel 603. Furthermore, the plate 602 has been provided with machined conduits 606, 607 that communicate with the inner space of channel 603 and that act as liquid influx and outflux conduits, respectively, allowing a flow of liquid to be caused through the channel 603 and, accordingly, between the windows 604, 605. Sample holders of this type are known in the art: see, for example, the above-mentioned *Hummingbird* website.

In practice, the sample holder 600 is provided with liquid supply/removal tubes connected to conduits 606, 607 and is mounted onto the manipulator 112 of Figure 1, which can then be moved so as to position the windows 604, 605 along the imaging axis (electron-optical axis) of the depicted electron microscope. However, since the employed electron microscope is a "flash-type" microscope, it can only image in bursts, and is therefore unable to continually "see" the position of a particular (moving) sample within the channel 603.

### Embodiment 1

Figure 3 schematically depicts a portion of an embodiment of an imaging apparatus according to the present invention.

The Figure depicts the vicinity of a central region of a sample holder 600 such as that illustrated in Figure 2. Item 603 is a flow channel in which there is a flow F of liquid water or other suitable liquid/solution. Suspended in this flow F are various biological specimens - such as cells, for example - and a particular one of these is designated as a sample S, which is to be further investigated. Carried by the flow F, the sample S will eventually traverse the space delimited by the TEM-transparent windows 604 and 605 and, in so doing, will cross the path of the (nominal) electron-optical axis O of a TEM (not explicitly depicted). It is desirable to know when the sample S will be at or proximal to the axis O, so that the TEM can be triggered to make a flash-exposure at that time.

To this end, two opposing boundary walls B of the vacuum housing 120 (see Figure 1) have been provided with transparent windows W1, W2, which transmit optical radiation of a chosen wavelength (that may be in the visible or infrared spectrum, for example). A light source L directs an incident light beam (schematically depicted by a single ray R) through window W1 and onto a first deflecting mirror M1, which is thus positioned/oriented as to direct this light beam onto the confinement plane P (channel 603) of the sample S in the vicinity of the axis O. If this light beam impinges upon a specimen in the channel 603, it will be returned (reflected/scattered) by the specimen in question toward a second deflecting mirror M2, which serves to direct this returned light through window W2 into a detector set-up D. In particular, light returned from the specimen S as it intercepts the light beam will be registered by D.

In a possible embodiment, the light source L is a laser and the detector D is a relatively simple intensity detector (such as a photodiode array), whence the depicted set-up acts as a laser backscatter analyzer.

In an alternative embodiment, the detector set-up D is a full optical microscope, including dedicated imaging optics.

In a further embodiment, the light source L is selected to emit a wavelength that excites fluorescence in the sample S, and the set-up D is a fluorescence microscope.

It should be explicitly noted that such a set-up allows the sample S to be both detected by the optical location sub-assembly (L, W1, M1, M2, W2, D) and imaged by the electron-optical imaging sub-assembly (which projects a flash-type electron beam along axis O) *without* requiring intervening adjustment of the orientation of the sample holder 600 or any special retraction / folding away of part of the locating sub-assembly prior to imaging.

### Embodiment 2

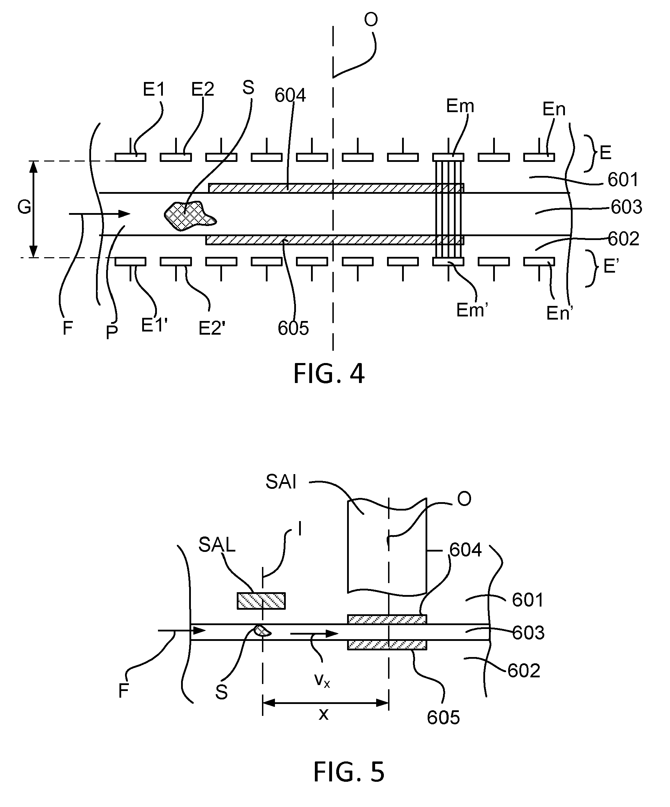

Figure 4 schematically depicts a portion of another embodiment of an imaging apparatus according to the present invention.

Once again, the Figure depicts the vicinity of a central region of a sample holder 600 such as that illustrated in Figure 2 or 3 (whereby parts corresponding to associated parts in Figures 2 or 3 are labeled using the same reference symbols, where appropriate); however, in the current case, the present view is more zoomed-in than Figures 2 or 3, and now only depicts the portion of the channel 603 delimited by the TEM-transparent windows 604 and 605.

Disposed above and below this channel 603, and running parallel to the confinement plane P, are mutually facing electrodes E and E'. These electrodes E and E' are, in fact, composite structures, comprising an array of sub-electrodes E1, E2,..., En and E1', E2',..., En', respectively, in which the members of each given pair (Em, Em') of such sub-electrodes are disposed so as to face each other across the intervening channel 603 at a constant separation (gap) G. These arrays of sub-electrodes may, for example, by manufactured using silk screening or lithographic techniques to create a suitable metallized pattern of pads on an electron-transparent carrier plate; these pads are then connected to respective voltage sources using wires / conductive tracts (not explicitly depicted).

An electrical potential difference is applied between the electrodes E, E', thus creating an electric field - or, in fact, an array of sub-fields - across the gap G. One such sub-field V is schematically depicted between sub-electrodes (Em, Em'). If the capacitance between the electrodes E, E' is measured, its value at a given time will depend on the dielectric constant of the particular constitution of medium present in the channel 603 at that time. More specifically, the capacitance between sub-electrodes (Em, Em') will depend on the constitution of the medium in the gap between (Em, Em') at any given time. Consequently, if the sample S drifts between sub-electrodes (Em, Em'), is presence will be registered as a particular capacitance change. In this way, by monitoring the capacitances between successive pairs of sub-electrodes (E1, E1'), (E2, E2'),..., (En, En'), one can electrically track the movement of the sample S through the channel 603, and can instigate electron-optical imaging *via* an electron flash along the axis O at a point of time when S is at or proximal to O.

Once again, it should be explicitly noted that such a set-up allows the sample S to be both detected by the capacitive location sub-assembly (E, E') and imaged by the electron-optical imaging sub-assembly (via a flash-type electron beam along axis O) *without* requiring interposed adjustment of the orientation of the sample holder 600 or any special retraction/stowing of part of the locating sub-assembly prior to imaging.

### Embodiment 3

Figure 5 schematically depicts an aspect of yet another embodiment of an imaging apparatus according to the present invention.

Whereas the configurations depicted in Figures 3 and 4 were "on-axis" configurations - whereby both the locating sub-assembly and the imaging sub-assembly were (substantially) centered about a common axis O and could *concurrently* locate/image a sample S - the configuration depicted in Figure 5 is an "off-axis" configuration, whereby the locating sub-assembly SAL has a measurement axis I (and, thus, also a field of measurement) that is distal from the imaging axis O of the imaging sub-assembly SAI (and, thus, also, its field of view). In particular, relative to the flow F, the locating sub-assembly SAL is displaced *upstream* with respect to the imaging sub-assembly SAI by a distance interval x, such that a sample S moving with the flow F will pass the axis I (i.e. traverse the field of measurement of SAL) before it passes the axis O (i.e. traverses the field of view of SAI). Consequently, in the current arrangement, locating and imaging events for a given sample S are no longer concurrent.

As set forth above, since SAL is now somewhat removed from SAI, the former can be embodied to work on the basis of different operating principles to those set forth in Embodiments 1 and 2 above (although it is still possible to successfully use the above-mentioned optical and capacitive locating techniques in the current context, if desired); for example, one could choose SAL to work on the basis of X-ray detection, SPM, NMR, or ultrasound detection.

In any case, SAL can be used to detect the passage of sample S at axis I, and to determine its velocity Vₓ in the x direction (flow direction). This value of Vₓ is then used together with the known value of the spatial interval x to calculate the expected time-of-arrival of S at axis O of SAI, allowing a flash-exposure to be planned to occur at that time.

Just as before, such a set-up allows the sample S to be both detected by SAL and imaged by SAI (via a flashed electron beam along axis O) *without* requiring intermediate adjustment of the orientation of the sample holder or any special retraction/stowing of (part of) SAL.

## Claims

1. An imaging apparatus comprising:
An imaging sub-assembly, in which an electron microscope is arranged to acquire an image of a sample that can be located in a sample holder, said image being acquired using an imaging beam that can be switched so as to
produce a flash of imaging electrons,
**characterized in that** the apparatus additionally comprises:
A locating sub-assembly, which does not employ electron microscopy, and which can be employed to determine a location of the sample relative to the imaging beam.

2. An imaging apparatus according to claim 1, wherein:
- The sample is a moving sample;
- Location information from the locating sub-assembly is employed to determine a commencement time for said flash in a given imaging event.

3. An imaging apparatus according to claim 1 or 2, wherein a field of view of the imaging sub-assembly is substantially coincident with a field of detection of the locating sub-assembly, thus allowing concurrent locating and imaging of the sample.

4. An imaging apparatus according to claim 2, wherein a field of view of the imaging sub-assembly and a field of detection of the locating sub-assembly are mutually displaced, said fields being disposed with respect to one another in such a manner that a moving sample in the sample holder will traverse said field of detection before traversing said field of view, the imaging apparatus further comprising a processor that calculates the commencement time of the flash using data that comprise the relative displacement of said fields and the velocity of the sample.

5. An imaging apparatus according to any of claims 1-4, wherein the locating sub-assembly comprises a light source and an optical detector.

6. An imaging apparatus according to claim 5, wherein the locating sub-assembly comprises a device chosen from the group comprising an optical microscope and a laser backscatter analyzer.

7. An imaging apparatus according to claim 6, wherein the light source is capable of exciting fluorescence in the sample, and the device is a fluorescence microscope.

8. An imaging apparatus according to any of claims 1-4, wherein the locating sub-assembly comprises a device chosen from the group comprising an ultrasonic analyzer, a capacitance analyzer, a magnetic field analyzer, an X-ray analyzer, a Scanning Probe Microscope (SPM) and a Nuclear Magnetic Resonance (NMR) analyzer.

9. An imaging apparatus according to any of claims 1-8, wherein the electron microscope is a Transmission Electron Microscope (TEM).

10. An imaging apparatus according to any of claims 1-8, wherein the electron microscope is chosen from the group comprising a Scanning Electron Microscope (SEM) and a Scanning Transmission Electron Microscope (STEM).

11. A method of imaging a sample using electron microscopy, comprising the following steps:
- Providing an imaging sub-assembly comprising an electron microscope that has a sample holder for accommodating the sample and that produces an imaging beam that is switchable so as to produce a flash of imaging electrons, and;
- Irradiating the sample with a flash of imaging electrons when the sample is appropriately positioned within a field of view of the electron microscope, **characterized by**:
- Employing a locating sub-assembly, which does not employ electron microscopy, to determine the location of the sample with respect to a reference point within said field of view.

12. A method according to claim 11, comprising the following additional steps:
- Causing the sample to follow a movement path along the sample holder, whereby the sample first traverses a field of detection of the locating sub-assembly and subsequently traverses a field of view of said imaging sub-assembly;
- Calculating a commencement time for said flash, using location information from the locating sub-assembly, the relative displacement of said fields, and the velocity of the sample;
- Initiating a flash at the calculated commencement time, thus imaging the sample.
